(19)

Europäisches
Patentamt
European
Patent Office
Office européen
des brevets

(11)　**EP 2 722 362 A1**

(12)　**EUROPEAN PATENT APPLICATION**
published in accordance with Art. 153(4) EPC

(43) Date of publication:
**23.04.2014　Bulletin 2014/17**

(51) Int Cl.:
**C08L 27/16** [(2006.01)]　　**B32B 27/30** [(2006.01)]
**C08K 3/22** [(2006.01)]　　**H01L 31/042** [(2014.01)]

(21) Application number: **12800833.1**

(22) Date of filing: **27.04.2012**

(86) International application number:
**PCT/JP2012/061331**

(87) International publication number:
**WO 2012/172876 (20.12.2012 Gazette 2012/51)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.06.2011　JP 2011133008**

(71) Applicant: **Kureha Corporation
Tokyo 103-8552 (JP)**

(72) Inventors:
• **HOSODA, Tomonori
Tokyo 103-8552 (JP)**

• **SATO, Yusuke
Tokyo 103-8552 (JP)**
• **OBA, Hiroyuki
Tokyo 103-8552 (JP)**
• **AKATSU, Masamichi
Ibaraki 300-0121 (JP)**
• **KOMATSUZAKI, Tetsuya
Ibaraki 300-0121 (JP)**

(74) Representative: **HOFFMANN EITLE
Patent- und Rechtsanwälte
Arabellastrasse 4
81925 München (DE)**

(54)　**POLYVINYLIDENE FLUORIDE RESIN FILM, MULTILAYER FILM, BACKSHEET FOR SOLAR CELL MODULE, AND FILM MANUFACTURING PROCESS**

(57)　　The invention provides a polyvinylidene fluoride resin (PVDF) film in which a crystal structure determined from an absorbance by an infrared absorption spectrum is such that a proportion of a β-type crystal is 10% or more based on the sum total of an α-type crystal and the β-type crystal, further preferably a film whose tensile modulus in TD at 120°C is 90 MPa or less, or a film in which a ratio of its tensile modulus in TD at a temperature of 100°C to its tensile modulus in TD at a temperature of 23°C is 4% or less, in particular an extruded film, a backsheet for solar cell module, which comprises the film, and a production process of the film, which comprises quenching a PVDF sheet-shaped material melt-extruded at 5 to 70°C and preferably then subjecting the quenched material to a heat treatment.

EP 2 722 362 A1

**Description**

TECHNICAL FIELD

The present invention relates to a polyvinylidene fluoride resin film and specifically relates to a polyvinylidene fluoride resin film free of occurrence of wrinkles by heat and excellent in suitability for lamination and a production process of the polyvinylidene fluoride resin film. The present invention also relates to a multilayer film comprising the polyvinylidene fluoride resin film, and a backsheet for solar cell module, which comprises the polyvinylidene fluoride resin film.

BACKGROUND ART

A polyvinylidene fluoride resin (hereinafter may referred to as "PVDF") is widely used in fields of which long-term durability is required by making good use of excellent weatherability, heat resistance, stain resistance, chemical resistance, solvent resistance, mechanical properties and secondary processability thereof. In particular, a film formed of PVDF is widely used in interior and exterior members of an architectural structure, a container surface material of which chemical resistance and organic solvent resistance are required, and further front surface and back surface protecting materials for a solar cell module, a fuel cell member, etc. for which long-term reliability is important, as a protecting material of various surfaces making good use of cost benefit by thinning the film.

Toward the recent promotion of global warming countermeasures, development of clean energy has been actively conducted. Among others, photovoltaic power generation utilizing sunlight is greatly expanded centering on Europe and America, and spread of a solar cell progresses. The PVDF excellent in weatherability, heat resistance, stain resistance, chemical resistance, solvent resistance, mechanical properties and secondary processability has come to be used in the form of a single layer or a laminate with any other thermoplastic resin layer as a front surface or back surface protecting material for a solar cell module used in photovoltaic power generation.

The solar cell is a generator directly converting sunlight to electric energy. The solar cell is roughly divided into a cell using a silicon semiconductor as a material and a cell using a compound semiconductor as a material. The silicon semiconductor solar cell includes a single crystal silicon solar cell, a polycrystalline silicon solar cell and an amorphous silicon solar cell.

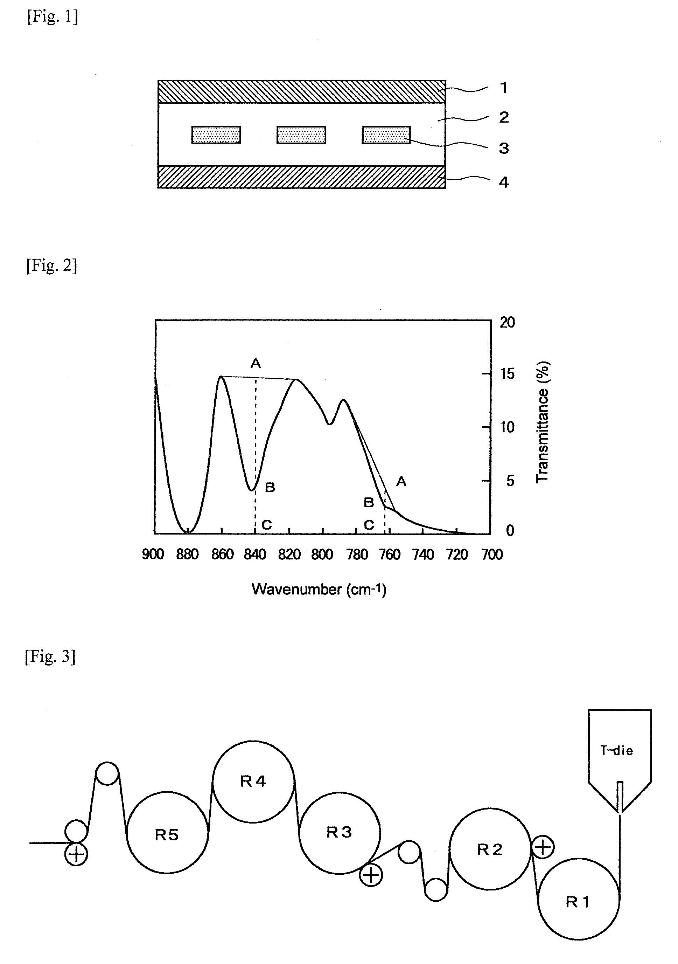

A typical structure of the solar cell is formed from a front surface protecting material, a sealing material, solar cells, a back surface protecting material and a frame. As illustrated in FIG. 1, main components of the solar cell include a front surface protecting material 1, a sealing material 2, solar cells 3 and a back surface protecting material 4. A plurality of the solar cells 3 is connected in series by wirings (not illustrated) to form a solar cell module. That is, that obtained by arranging and connecting a plurality of solar cells and packaging them with a front surface protecting material, a sealing material and a back surface protective material (hereinafter may referred to as "backsheet") is called a solar cell module. A frame (not illustrated) is arranged at end portions or peripheral edge portions of the solar cell module.

As the front surface protecting material 1, is used, for example, a reinforced glass plate, a transparent plastic plate or a transparent plastic film. As the sealing material 2, is commonly used an ethylene-vinyl acetate copolymer. As the back surface protecting material 4, is used, for example, a single-layer or multi-layer plastic film, a plastic plate, a reinforced glass plate or a metal plate (for example, aluminum plate or painted steel plate). As the frame, is commonly used, for example, aluminum light in weight and excellent in environmental resistance.

The solar cell module is generally placed in the outdoors, and its operation state is thereafter retained over a long period of time. In order to satisfactorily operate the solar cell module over a long period of time in the outdoors, it is necessary for such a module to have excellent durability under a severe environment. Therefore, the front surface protecting material, sealing material and back surface protecting material of the solar cell module are required to have a function of protecting the solar cells over a long period of time under a severe natural environment surrounding the solar cell module.

In the backsheet for solar cell module, its surface (outermost surface) distant from the solar cells is exposed directly to the outdoors. A surface (surface adjoining the sealing material) of the backsheet for solar cell module, which is close to the solar cells, is exposed to sunlight passing through between respective solar cells or between respective solar cell modules. Therefore, the backsheet for solar cell module is required to be excellent in various properties such as light resistance, weatherability, heat resistance, moisture resistance, oxygen or water vapor barrier property, electrical insulating property, withstand voltage, mechanical properties, chemical resistance, salt resistance, stain resistance and adhesion property to sealing materials.

The backsheet for solar cell module is also required to be beautiful in the appearance of the surface on the side of the solar cells and additionally to have a function of efficiently reflecting sunlight incident on the backsheet in addition to the above excellent various properties. If the incident light passed through between the respective solar cells can be efficiently reflected by the backsheet, the power conversion efficiency of the solar cells is improved by the reflected light. Therefore, a backsheet containing a colorant such as titanium oxide is also known.

As a plastic film used as the backsheet for solar cell module, a fluororesin film, a polyethylene terephthalate (hereinafter may referred to as "PET") film and a composite film thereof have come to be preferably used from the viewpoint of satisfying the various properties required of the backsheet for solar cell module. Among these, the fluororesin film or the composite film of the fluororesin film has come to be more preferably used from the viewpoints of light resistance, weatherability, heat resistance, stain resistance, etc. (see Patent Literature 1).

A PVDF film is suitable for use as the fluororesin film for the backsheet for solar cell module because that film is far excellent in light resistance, weatherability, stain resistance, heat resistance, etc.

For example, a backsheet for solar cell module, which is formed of a composite film comprising a PVDF film, is known as a film combined with weatherability, stain resistance, heat resistance, mechanical properties, etc. In particular, a backsheet for solar cell module, which comprises a PVDF layer and a PET layer, is known (see Patent Literatures 2 to 4).

Regarding the backsheet for solar cell module, requirement for long-term reliability becomes more and more tight, and the PVDF film is required to be used under severe conditions and to have an ultra-long service life, so that the film is required to have far excellent weatherability, heat resistance, mechanical properties, etc.

In addition, in order to produce a composite film preferably used as the backsheet for solar cell module and obtained by laminating a PVDF film and a PET film, a thermal lamination process in which the PVDF film and the PET film are bonded and laminated while being heated and pressurized is generally adopted. However, a problem that wrinkles by heat may occur on the PVDF film at that time has been found. When the wrinkles by heat occur on the PVDF film, not only the beautiful appearance of the backsheet exposed to the outdoors is impaired, but also such problems that peel strength and adhesion durability between the PVDF film and the PET film become insufficient, and the reflection efficiency of the sunlight is lowered are caused. Thus, there has been a demand for improvement.

CITATION LIST

PATENT LITERATURE

Patent Literature 1: Japanese Patent Application Laid-Open No. 2003-347570
Patent Literature 2: Japanese Patent Application Laid-Open No. 2003-251765
Patent Literature 3: Japanese Patent Application Laid-Open No. 2008-181929
Patent Literature 4: Japanese Patent Application Laid-Open No. 2009-71236

SUMMARY OF INVENTION

Technical Problem

It is an object of the present invention to provide a PVDF film excellent in light resistance, weatherability, stain resistance, heat resistance, etc. and also excellent in mechanical properties, free of occurrence of wrinkles by heat even when laminated with a PET film in a lamination process and suitable for use as a backsheet for solar cell module. Solution to Problem

The present inventors have carried out extensive researches with a toward achieving the above object. As a result, it has been found that regarding a crystal structure in the PVDF film, a proportion of a specific crystal structure is controlled within a specific range, whereby the above object can be achieved, thus leading to completion of the present invention.

According to the present invention, there is thus provided a PVDF film in which a crystal structure determined from an absorbance by an infrared absorption spectrum is such that a proportion of a $\beta$-type crystal is 10% or more when the sum total of an $\alpha$-type crystal and the $\beta$-type crystal is regarded as 100%.

According to the present invention, there are also provided PVDF films respectively characterized by the following (1) to (5) as embodiments.

(1) The PVDF film which comprises 100 parts by mass of a PVDF, 0 to 40 parts by mass of another thermoplastic resin and 5 to 100 parts by mass of titanium oxide.
(2) The PVDF film, wherein the thickness thereof is 10 to 50 $\mu$m.
(3) The PVDF film, wherein the film is an extruded film.
(4) The PVDF film, wherein its tensile modulus in TD at a temperature of 120°C is 90 MPa or less.
(5) The PVDF film, wherein a ratio of its tensile modulus in TD at a temperature of 100°C to its tensile modulus in TD at a temperature of 23°C is 4% or less.

According to the present invention, there is further provided a multilayer film comprising the PVDF film.

According to the present invention, there is still further provided a backsheet for solar cell module, comprising the PVDF film or multilayer film.

According to the present invention, there is yet still further provided a production process of the PVDF film, comprising quenching a sheet-shaped material melt-extruded at a temperature of 5 to 70°C, and preferably provided a production process of the PVDF film, comprising subjecting the sheet-shaped material quenched to a heat treatment at a temperature of 75 to 150°C.

ADVANTAGEOUS EFFECTS OF INVENTION

According to the present invention, the PVDF film is a PVDF film in which a crystal structure determined from an absorbance by an infrared absorption spectrum is such that a proportion of a β-type crystal is 10% or more when the sum total of an α-type crystal and the β-type crystal is regarded as 100%, and preferably a film, wherein its tensile modulus in TD at a temperature of 120°C is 90 MPa or less, or wherein a ratio of its tensile modulus in TD at a temperature of 100°C to its tensile modulus in TD at a temperature of 23°C is 4% or less, thereby exhibiting an effect that the resultant PVDF film has excellent mechanical properties and is free of occurrence of wrinkles by heat upon lamination under heat. In addition, the PVDF film or the multilayer film comprising the PVDF film is used, thereby exhibiting an effect that a backsheet for solar cell module, which is rich in long-term reliability, is obtained.

In addition, the sheet-shaped material melt-extruded is quenched and preferably subjected to a heat treatment, thereby exhibiting an effect that a production process of the PVDF film having the above-described excellent properties is provided.

BRIEF DESCRIPTION OF DRAWINGS

[FIG. 1] FIG. 1 schematically illustrates a section of an exemplary solar cell module.

[FIG. 2] FIG. 2 is an exemplary graph illustrating characteristic absorption of an α-type crystal and a β-type crystal in an infrared absorption spectrum diagram of a PVDF film.

[FIG. 3] FIG. 3 schematically illustrates an exemplary production process of a PVDF extruded film according to the present invention.

DESCRIPTION OF EMBODIMENTS

1. Polyvinylidene fluoride resin (PVDF)

The PVDF used in the PVDF film according to the present invention means a homopolymer of vinylidene fluoride or a vinylidene fluoride copolymer comprising vinylidene fluoride as a principal component.

Examples of the vinylidene fluoride copolymer include vinylidene fluoride-hexafluoropropylene copolymers, vinylidene fluoride-tetrafluoroethylene copolymers, vinylidene fluoride-chlorotrifluoroethylene copolymers, vinylidene fluoride-trifluoroethylene copolymers, vinylidene fluoride-tetrafluoroethylene-hexafluoropropylene terpolymers, vinylidene fluoride-chlorotrifluoroethylene-hexafluoropropylene terpolymers and mixtures of two or more polymers thereof.

In these vinylidene fluoride copolymers, the copolymerization ratio of the comonomer(s) is preferably 15 mol% or less, more preferably 10 mol% or less, particularly preferably 5 mol% or less. When the copolymerization ratio of the comonomer(s) is 15 mol% or less, such a vinylidene fluoride copolymer becomes a crystalline thermoplastic resin. The lower limit of the proportion of the comonomer(s) is preferably 1 mol%. If the copolymerization ratio of the comonomer(s) is too high, such a vinylidene fluoride copolymer loses crystallinity and becomes an elastomer. A vinylidene fluoride copolymer which becomes an elastomer by losing crystallinity is not a PVDF for forming the PVDF film according to the present invention.

Accordingly, at least one polymer selected from the group consisting of a homopolymer of vinylidene fluoride and vinylidene fluoride copolymers whose copolymerization ratio of the comonomer(s) is 15 mol% or less may be used as the PVDF for forming the PVDF film according to the present invention. Among these PVDF polymers, the vinylidene fluoride homopolymer and vinylidene fluoride-hexafluoropropylene copolymers containing a hexafluoropropylene unit in a proportion of 15 mol% or less are particularly preferred from the viewpoints of heat resistance, melt formability or moldability, mechanical properties, stain resistance, solvent resistance, secondary processability, etc.

The PVDF can be prepared by a suspension polymerization process or emulsion polymerization process. In the emulsion polymerization process, a chemically stable fluorinated emulsifier is used to emulsify vinylidene fluoride alone or vinylidene fluoride and a comonomer such as hexafluoropropylene in an aqueous medium. An inorganic peroxide, organic peroxide, organic percarbonate compound or the like is then used as a polymerization initiator to conduct polymerization. After the emulsion polymerization, a fine latex of sub-micron unit is precipitated and aggregated with a flocculant, whereby the PVDF can be collected as particles having a proper size.

In the suspension polymerization process, a suspending agent such as methyl cellulose is used to suspend vinylidene fluoride or vinylidene fluoride and a comonomer in an aqueous medium. For example, an organic percarbonate (for example, di-n-propyl peroxydicarbonate) exhibiting activity at a low temperature is used as a polymerization initiator to initiate polymerization at a temperature not higher than the critical temperature of vinylidene fluoride of 30.1°C, preferably 10 to 30°C, more preferably 20 to 28°C, thereby forming primary polymer particles, and the temperature is raised to 30 to 90°C, preferably 40 to 80°C, as needed, to continue the polymerization reaction, thereby forming secondary polymer particles.

The intrinsic viscosity of the PVDF is within a range of preferably 0.70 to 1.50 dl/g, more preferably 0.80 to 1.30 dl/g. The intrinsic viscosity of the PVDF is a logarithmic viscosity at 30°C of a solution with 4 g of the PVDF dissolved in 1 liter of N,N-dimethylformamide as measured by means of an Ubbellohde viscometer.

The melting point of the PVDF is within a range of generally 130 to 177°C, often 150 to 177°C. The melting point of the PVDF is a value measured by means of a differential scanning calorimeter (DSC). When the PVDF is heated to a temperature of 350°C or more, HF gas is generated to decompose the polymer. The PVDF has a wide processable temperature range from its melting point to its decomposition point. The melt-processable temperature of the PVDF is generally within a range of generally 200 to 250°C, preferably 210 to 240°C.

2. Titanium oxide

The PVDF film according to the present invention preferably contains titanium oxide in addition to the PVDF. When the PVDF film according to the present invention is used in a backsheet for solar cell module in particular, improvements in shielding property and reflection efficiency can be realized by containing titanium oxide.

As titanium oxide, those having 2 crystal forms of anatase-type and rutile- type are widely used. In the present invention, those of these 2 crystal forms may be used. Among these, titanium oxide having a rutile-type crystal form is preferred because it is excellent in dispersibility in the PVDF at a high temperature and extremely small in volatility.

As titanium oxide, that of the grade for pigment may be preferably used. The average particle diameter (average primary particle diameter) of titanium oxide according to the image analysis of an image taken by a transmission electron microscope is within a range of generally 150 to 1,000 nm, preferably 200 to 700 nm, more preferably 200 to 400 nm. If the average particle diameter of titanium oxide is too small, its shielding ability is lowered. The average particle diameter of titanium oxide falls within the above range, whereby its refractive index becomes high, and so the light scattering ability thereof is strong, so that its shielding ability as a white pigment becomes high. Titanium oxide is generally present in the form of secondary particles with primary particles aggregated. The specific surface area of titanium oxide as measured by the BET method is within a range of generally 1 to 15, often 5 to 15.

Titanium oxide is subjected to a surface treatment with a surface treatment agent, whereby its properties such as dispersibility, shielding property and weatherability can be improved. Examples of the surface treatment agent include oxides of metals such as aluminum, silicon, zirconium, tin, cerium and bismuth; hydrated metal oxides such as zinc oxide; organic metal compounds such as organic aluminum compounds, organic titanium compounds and organic zirconium compounds; organic silicon compounds such as silane coupling agents and polysiloxanes; phosphorus compounds such as aluminum phosphate and organic phosphates; and amine compounds.

Titanium oxide is coated with the surface treatment agent, whereby a reaction between the surface of titanium oxide and a surrounding environment can be inhibited. The titanium oxide surface-treated is excellent in dispersibility in the PVDF. The titanium oxide surface-treated can be dispersed at a high concentration in the PVDF. Incidentally, when titanium oxide surface-treated with the same substance as that used as a heat stabilizer which will be described subsequently is used, the amount of the surface treatment agent adhered is extremely small, so that the amount of the surface treatment agent may not be included in the amount of the heat stabilizer used in the present invention.

The content of titanium oxide in the PVDF film according to the present invention is within a range of generally 5 to 100 parts by mass, preferably 10 to 90 parts by mass, more preferably 15 to 80 parts by mass, particularly preferably 20 to 70 parts by mass per 100 parts by mass of the PVDF. If the content of titanium oxide is too low, it is difficult to provide a resin film having a whiteness degree, shielding ability and reflection efficiency sufficient to be used as, for example, a backsheet for solar cell module. If the content of titanium oxide is too high, it is difficult to produce a resin film by extrusion, and moreover the mechanical strength of the resulting resin film is lowered.

3. Another thermoplastic resin

The PVDF film according to the present invention may contain the PVDF alone as a resin component. However, another thermoplastic resin may be contained, as needed, for improving properties such as processability, impact resistance, adhesion property and heat resistance.

Examples of another thermoplastic resin include polyolefins such as polyethylene and polypropylene; fluororesins such as polytetrafluoroethylene and polyvinyl fluoride; polyamides such as nylon 6 and nylon 66; polyesters such as polyethylene terephthalate, polybutylene terephthalate and polyethylene naphthalate; acrylic resins such as polymethyl methacrylate; and polystyrene, polyacrylonitrile, polyvinyl chloride, polyoxymethylene, polycarbonate, poly(phenylene oxide), polyester urethane, poly(m-phenylene isophthalamide) and poly(p-phenylene terephthalamide).

As another thermoplastic resin, is particularly preferred polymethyl methacrylate (hereinafter may referred to as "PMMA") compatible with the PVDF. PMMA is excellent in compatibility with the PVDF and moreover can improve the adhesion property of a resin film formed from a composition containing the PVDF to another member, for example, another thermoplastic resin film. Examples of PMMA include a homopolymer of methyl methacrylate, and besides copolymers containing a methyl methacrylate monomer in a proportion exceeding 50 mol% and an acrylic ester or another methacrylic ester than methyl methacrylate in a proportion less than 50 mol% as constituent units and mixtures of two or more polymers thereof. As examples of the acrylic ester and another methacrylic ester than methyl methacrylate, may be mentioned methyl acrylate, ethyl acrylate, propyl acrylate and butyl acrylate, and ethyl methacrylate and propyl methacrylate, respectively.

Another thermoplastic resin may be contained in an amount within a range of preferably 0 to 40 parts by mass, more preferably 0 to 35 parts by mass, still more preferably 5 to 30 parts by mass, particularly preferably 10 to 25 parts by mass per 100 parts by mass of the PVDF.

4. Other additives

The PVDF film according to the present invention may further contain other additives such as a pigment or dye, a pigment dispersant, an ultraviolet absorbent, a heat stabilizer, a light stabilizer, a delustering agent, a lubricant, a crystal nucleating agent and a mechanical property improver, if desired, in addition to the PVDF, and titanium oxide and another thermoplastic resin incorporated if desired as described above.

For example, the PVDF film according to the present invention may contain the mechanical property improver. The mechanical property improver can improve the mechanical properties, such as impact resistance, tensile strength and elongation, of the resulting PVDF film, and, for example, a core-shell type impact improver and an acrylic copolymer-based fluidity improver are known. The mechanical property improver may be selected, as a commercially available product, from KANE ACE (trademark) available from Kaneka Corporation, METABLEN (trademark) available from Mitsubishi Rayon Co., Ltd. and PARALOID (trademark) available from Rohm and Haas Co. The mechanical property improvers may be used either singly or in any combination thereof.

The PVDF film according to the present invention may contain the heat stabilizer. Examples of the heat stabilizer include calcium polyhydroxymonocarboxylates such as calcium gluconate; calcium salts of aliphatic carboxylic acids having 5 to 30 carbon atoms, such as calcium stearate and calcium oleate; inorganic calcium compounds such as calcium carbonate and calcium hydroxide, and metal oxides such as zinc oxide and magnesium oxide. The heat stabilizers may be used either singly or in any combination thereof. These heat stabilizer is generally used in the form of powder from the viewpoint of dispersibility in the PVDF. For example, the inorganic calcium compounds such as calcium carbonate and the metal oxide such as zinc oxide preferably have an average particle diameter (average primary particle diameter) within a range of 0.05 to 2 $\mu$m as measured according to the image analysis of an image taken by a transmission electron microscope. The effect to improve the thermal decomposition temperature of the PVDF can be more exhibited as this average particle diameter becomes smaller. In order to efficiently enhance the heat stability improving effect by the heat stabilizer, the content of the heat stabilizer is preferably controlled according to the content of titanium oxide in the PVDF film. The content of the heat stabilizer is generally made lower than the content of titanium oxide. A mass ratio of titanium oxide to the heat stabilizer is within a range of generally 100:1 to 3:1, preferably 80:1 to 4:1, more preferably 50:1 to 5:1.

These other additives are used in their suitable proportions. When the other additives are contained, the proportions of the additives are, independently of one another, within a range of generally 0.001 to 20 parts by mass, preferably 0.1 to 15 parts by mass, more preferably 0.3 to 10 parts by mass, particularly preferably 0.5 to 8 parts by mass per 100 parts by mass of the PVDF. When the other additive is the heat stabilizer in particular, the heat stability improving effect becomes small if the content of the heat stabilizer is too low, so that it is difficult to sufficiently inhibit the lowering of the thermal decomposition temperature of the PVDF component in the resulting PVDF film. If the content of the heat stabilizer is too high, there is a possibility that the shielding ability, color tone, mechanical properties, etc. of the resulting resin film may be adversely affected.

5. PVDF film

The PVDF film according to the present invention is a PVDF film in which a crystal structure determined from an absorbance by an infrared absorption spectrum is such that a proportion of a $\beta$-type crystal is 10% or more when the sum total of an $\alpha$-type crystal and the $\beta$-type crystal is regarded as 100%.

[Proportion of $\beta$-type crystal]

The PVDF is known as a resin having high crystallinity, and it is known that three crystal structures of $\alpha$-type (also referred to as "II-type"), $\beta$-type (also referred to as "I-type") and $\gamma$-type (also referred to as "III-type") are roughly present as crystal structures thereof. When the PVDF is cooled from a molten state to provide a film, the film has been known to have an $\alpha$-type crystal structure. However, the PVDF film according to the present invention is characterized in that the film contains a $\beta$-type crystal in a proportion of 10% or more.

The $\alpha$-type crystal and $\beta$-type crystal in the PVDF film can be identified by an infrared absorption spectrum as measured by a transmission method using an infrared spectrophotometer.

A specific measuring method is as follows.

As exemplified by an infrared absorption spectrum diagram illustrated in FIG. 2, absorption intensity at a wavenumber of 765 cm$^{-1}$ that is characteristic absorption of the $\alpha$-type crystal and absorption intensity at a wavenumber of 840 cm$^{-1}$ that is characteristic absorption of the $\beta$-type crystal are determined from the resultant spectrum. That is, start and end points forming each peak corresponding to the wavenumber are linked by a straight line, an intersection of the straight line with the peak wavenumber is regarded as A, a point where the spectrum intersects the peak wavenumber is regarded as B, a point where a transmittance is 0% at the peak wavenumber is regarded as C, length between A and C and between B and C are determined, and Log (AC/BC) is regarded as absorption intensity at each wavenumber.

The proportion of the $\beta$-type crystal is calculated out according to the following equation by determined absorption intensities at the wavenumbers of 765 cm$^{-1}$ and 840 cm$^{-1}$ respectively corresponding to the $\alpha$-type crystal and the $\beta$-type crystal as described above. Incidentally, when a shoulder forming a peak is not observed at the wavenumber of 765 cm$^{-1}$ derived from the $\alpha$-type crystal, the $\alpha$-type crystal is regarded absent, and the proportion of the $\beta$-type crystal is determined to be 100%.

$$\text{Proportion of } \beta\text{-type crystal} = (\text{Absorption intensity at } 840 \text{ cm}^{-1})/[(\text{Absorption intensity at } 765 \text{ cm}^{-1}) + (\text{Absorption intensity at } 840 \text{ cm}^{-1})] * 100.$$

The PVDF film according to the present invention is a PVDF film in which a crystal structure determined from an absorbance by an infrared absorption spectrum is such that a proportion of a $\beta$-type crystal is 10% or more when the sum total of an $\alpha$-type crystal and the $\beta$-type crystal is regarded as 100%, and the proportion of the $\beta$-type crystal is preferably more than 10%, more preferably 40% or more, still more preferably 50% or more, particularly preferably 90% or more, most preferably 93% or more. The upper limit of the proportion of the $\beta$-type crystal is 100%, and the PVDF film according to the present invention may substantially not contain the $\alpha$-type crystal. If the proportion of the $\beta$-type crystal is less than 10%, wrinkles by heat upon lamination may occur in some cases, and in some cases, the flexibility of the film may become insufficient, and the anisotropy thereof may increase.

[Tensile modulus]

In the PVDF film according to the present invention, its tensile modulus in TD at a temperature of 120°C is preferably 90 MPa or less. That is, in such a case, the PVDF film according to the present invention has high probability that the tensile modulus in TD falls within less than 120 MPa in an environment of a temperature of 100°C or higher, which is generally adopted in a lamination step, so that the flexibility of the film is easily retained, and so the film does not have such force as to cause the deformation of an adhesive for lamination, and so the occurrence of wrinkles by heat upon the lamination can be more surely prevented. In addition, since the film is flexible, the film is rich in follow-up property to a shape upon use or installation when the film is used for, for example, a backsheet for solar cell module, so that such a film is also preferred from the viewpoint of improvement in durability. Incidentally, "TD" in the present specification means a direction perpendicular to an extrusion direction (may also referred to as "machine direction" or "MD") of the film. The tensile modulus in TD at the temperature of 120°C is more preferably 75 MPa or less, still more preferably 65 MPa or less, and the lower limit thereof is not particularly limited. However, the lower limit is generally 5 MPa, often 10 MPa from the viewpoint of preventing from becoming excessively flexible.

Further, in the PVDF film according to the present invention, a ratio (hereinafter may referred to as "temperature ratio between tensile moduli" of its tensile modulus in TD at a temperature of 100°C to its tensile modulus in TD at a temperature of 23°C is preferably 4% or less. That is, in such a case, since it is considered for the degree of lowering of the tensile modulus in TD of the PVDF film according to the present invention to become great as the temperature rises, the film has high probability that the tensile modulus in TD falls within less than 120 MPa in an environment of a temperature of 100°C or higher, which is generally adopted in a lamination step, so that the flexibility of the film is easily retained, and the film does not have such force as to cause the deformation of an adhesive for lamination. Thus, the occurrence of wrinkles by heat upon the lamination can be more surely prevented. The temperature ratio between tensile moduli is more preferably 3.8% or less, particularly preferably 3.5% or less, and the lower limit thereof is not particularly limited. However, the lower limit is generally 0.5% from the viewpoint of preventing from becoming excessively flexible.

The tensile modulus that is mechanical property of the film is measured by using, as a specimen, a strip film having a length of 200 mm and a width of 20 mm and obtained by cutting out the film in parallel with MD (machine direction) or TD according to JIS K 7127, setting the specimen in an oven controlled to a predetermined temperature, controlling the temperature for about 2 seconds and then conducting a tensile test. The tensile test is performed at a tensile speed of 10 mm/ by using TENSILON RTM-100 manufactured by Toyo Baldwin K.K.

For example, the specimen cut out in parallel with TD is set in an oven controlled to a temperature of 120°C to conduct the tensile test, whereby the tensile modulus in TD at the temperature of 120°C can be determined. In addition, the specimens cut out in parallel with TD are respectively set in an oven controlled to a temperature of 23°C and an oven controlled to a temperature of 100°C to conduct the tensile test, whereby the temperature ratio between the tensile moduli can be calculated out and determined from the resultant measured values of tensile moduli.

The PVDF film according to the present invention may be either an unstretched film or a stretched film. However, the unstretched film is preferred for controlling the proportion of the β-type crystal within the desired range.

The thickness of the PVDF film according to the present invention is generally 2 to 500 μm, preferably 3 to 400 μm, more preferably 5 to 300 μm, still more preferably 8 to 200 μm, particularly preferably 10 to 150 μm. When the PVDF film according to the present invention is processed into a multilayer film as described below, the thickness of the PVDF film is preferably 2 to 100 μm, more preferably 3 to 80 μm, still more preferably 4 to 60 μm, particularly preferably 10 to 50 μm. If the thickness of the PVDF film is less than 2 μm, the strength of the film is insufficient, and necessary mechanical properties cannot be achieved. As a result, wrinkles by heat may occur upon lamination in some cases. For example, when the film is used as a backsheet for solar cell module, it is difficult to achieve necessary properties such as shielding property and strength. If the thickness exceeds 500 μm, the flexibility of the film may become insufficient, and the anisotropy thereof may increase in some cases. In addition, it is impossible to lighten the weight of the backsheet or to thin the thickness thereof.

6. Production process of PVDF film

The PVDF film according to the present invention, which is a PVDF film in which a crystal structure determined from an absorbance by an infrared absorption spectrum is such that a proportion of a β-type crystal is 10% or more when the sum total of an α-type crystal and the β-type crystal is regarded as 100%, can be produced by strictly controlling production conditions in a production process known *per se* in the art. For example, a casting process in which a raw material mixture (hereinafter may referred to as "PVDF" merely) which is a composition containing the PVDF is dissolved or dispersed in an organic solvent, the resultant solution or dispersion is coated on a substrate, and the solvent is then volatilized and removed, a process in which PVDF powder is vacuum-deposited on a substrate, a process in which the PVDF is melted and kneaded at a temperature not lower than the melting point thereof, and the resultant kneaded product is then rolled between rolls into a film form, or a process in which the PVDF is melted and kneaded at a temperature not lower than the melting point thereof, and the resultant kneaded product is then extruded from a T-die or inflation die may be adopted.

The PVDF film according to the present invention is preferably produced by a process of obtaining an extruded film by extrusion because the control of the proportion of the β-type crystal in the crystal structure and the production efficiency of the film are excellent. A process for producing a PVDF extruded film using a T-die will hereinafter be described in detail.

After the PVDF, and another thermoplastic resin, titanium oxide and other additives are mixed in their predetermined amounts if desired, a material containing the PVDF is fed to an extruder and heated to a temperature not lower than the melting point of the PVDF to melt and knead the material, and the resultant kneaded product is melt-extruded in the form of a sheet from a T-die arranged on the tip of the extruder, whereby a PVDF extruded film can be produced. The melting and kneading temperature is within a range of generally 200 to 250°C, preferably 205 to 245°C, more preferably 210 to 240°C, and the extruding temperature from the T-die is within a range of generally 195 to 235°C, preferably 200 to 230°C, more preferably 205 to 225°C.

An unexpectable phenomenon that the PVDF film according to the present invention, which is a PVDF film in which a crystal structure determined from an absorbance by an infrared absorption spectrum is such that a proportion of a β-type crystal is 10% or more when the sum total of an α-type crystal and the β-type crystal is regarded as 100%, is obtained by quenching the sheet-shaped material extruded in the form of the sheet in a molten state from the T-die has been found. In addition, it has been found that the proportion of the β-type crystal in the film and its mechanical properties can be controlled by combining quenching conditions of the sheet-shaped material and conditions of a heat treatment subsequent to the quenching.

That is, the PVDF extruded in the form of the sheet in the molten state from the T-die is quenched by bringing it into contact with a first casting roll (R1) arranged just under the T-die and temperature-controlled to a predetermined temperature as illustrated in FIG. 3. The temperature of the first casting roll (R1) for conducting the quenching varies according to the temperature of the PVDF extruded and a film-forming speed. However, the temperature is within a range of generally 5 to 70°C, preferably 8 to 70°C, more preferably 10 to 68°C, still more preferably 15 to 66°C. If the temperature of the first casting roll (R1) is less than 5°C, the PVDF is quenched too rapidly, so that the resulting PVDF film becomes an amorphous film, and so the necessary mechanical strength cannot be achieved. If the temperature of the first casting roll (R1) exceeds 70°C, there is a possibility that it may be difficult to control the proportion of the β-type crystal in the resulting PVDF film to 10% or more. In addition, the contact of the sheet-shaped material of the PVDF melt-extruded with the first casting roll (R1) varies according to the film-forming speed. However, the position of the first casting roll (R1) is selected from ranges of generally 50 to 700 mm, preferably 70 to 600 mm and more preferably 80 to 500 mm just under the T-die. The temperature of the first casting roll (R1) may be strictly controlled by adopting a method known *per se* in the art, such as heating and cooling by a fluid such as water or oil, heating and cooling by an electric heater or heating and cooling by a piezoelectric element.

The sheet-shaped material of the PVDF quenched by the first casting roll (R1) is then guided to a second roll (R2) to a fifth roll (R5) which are temperature-controlled as needed to obtain a PVDF film. The number of rolls of the second roll (R2) to the fifth roll (R5) may be decreased or increased as needed. The rotational speeds of the first casting roll (R1) to the fifth roll (R5) are controlled, whereby the oriented states in MD (machine direction) and TD (transverse direction) and residual stress of the resulting PVDF film can be controlled.

The temperatures of the second roll (R2) to the fifth roll (R5) may be suitably selected, and their temperatures may be the same or different from one another. The temperatures may be ordinary temperature without making particular temperature control. However, the rolls are preferably heated to a temperature sufficient to heat-treat the sheet-shaped material quenched. The temperature of each of the second roll (R2) to the fifth roll (R5) is controlled within a range of preferably 75 to 150°C, more preferably 77 to 145°C, still more preferably 80 to 140°C, most preferably 75 to 120°C, whereby the mechanical strength of the resulting film can be improved. The temperature of each of the second roll (R2) to the fifth roll (R5) is made higher by preferably 20°C or more, more preferably 25°C or more, still more preferably 30°C or more than the temperature of the first casting roll (R1). The temperature of each of the second roll (R2) to the fifth roll (R5) may be strictly controlled by adopting the method known *per se* in the art as described above.

The sheet-shaped material quenched by the first casting roll (R1) or the quenched sheet-shaped material which is a PVDF film obtained by bring it into contact with the second roll (R2) to the fifth roll (R5) (the number and temperature of the roll may be suitably changed and controlled) subsequently to the quenching may be further subjected to a heat treatment to obtain a PVDF film. No particular limitation is imposed on a method for the heat treatment. For example, after the sheet-shaped material is brought into contact with the fifth roll (R5), it may be continuously subjected to a heat treatment in a heat treatment zone to obtain a PVDF film. In addition, after the PVDF film obtained by bringing the sheet-shaped material into contact with the fifth roll (R5) is wound around a roll, the rolled film may be left at rest in, for example, a temperature-controlled chamber as it is, thereby conducting a heat treatment to obtain the PVDF film. The heat treatment temperature is controlled within a range of preferably 75 to 140°C, more preferably 77 to 137°C, still more preferably 79 to 135°C, most preferably 75 to 120°C, whereby the mechanical strength and heat resistance of the resulting film can be still more improved. The heat treatment time varies according to the heat treatment temperature. However, the time may be set within a range of generally 5 seconds to 10 hours, often 10 seconds to 8 hours.

7. Multilayer film

The PVDF film according to the present invention may be used as a single-layer film. However, another thermoplastic resin film is laminated thereon to provide a multilayer film comprising the PVDF film, whereby the resultant film can be used in fields of which more improvement in mechanical strength such as impact resistance and flexibility is required.

Examples of another thermoplastic resin film used for forming the multilayer film comprising the PVDF film include films of polyolefins such as polyethylene and polypropylene; fluororesins such as polytetrafluoroethylene and polyvinyl fluoride; polyamides such as nylon 6 and nylon 66; polyesters such as polyethylene terephthalate, polybutylene terephthalate and polyethylene naphthalate (hereinafter may referred to as "PEN"); acrylic resins such as polymethyl methacrylate; and polystyrene, polyacrylonitrile, polyvinyl chloride, polyoxymethylene, polycarbonate, poly(phenylene oxide), poly(phenylene sulfide), poly(ether ether ketone), polyester urethane, poly(m-phenylene isophthalamide) and poly(p-phenylene terephthalamide). One or more of these films may be selected in view of necessary mechanical strength, heat resistance, weatherability, light resistance, etc.

When the multilayer film comprising the PVDF film is used as a backsheet for solar cell module, a film of a polyester such as PET or PEN; polycarbonate; or an acrylic resin such as PMMA is preferably used as another thermoplastic resin film from the viewpoints of properties required of the backsheet, such as mechanical strength such as impact resistance and flexibility, weatherability, shielding property, and adhesion property to sealing materials. A film of a polyester such as PET or PEN is particularly preferred, and a PET film is most preferably used. Among others, a biaxially stretched PET film is preferred.

An additional thermoplastic resin, and compounding additives such as a stabilizer, an ultraviolet absorbent and a pigment or dye may be contained in these other thermoplastic resin films as needed. When the multilayer film comprising the PVDF film is used as a backsheet for solar cell module in particular, titanium oxide added for improving shielding property may be contained in said another thermoplastic resin film.

No particular limitation is imposed on the thickness of the multilayer film. However, the thickness is generally 3 to 500 $\mu$m, preferably 7 to 400 $\mu$m, more preferably 10 to 300 $\mu$m, still more preferably 20 to 250 $\mu$m. If the thickness of the multilayer film is less than 3 $\mu$m, the strength of such a multilayer film becomes insufficient, and so there is a possibility that necessary mechanical properties may not be achieved. When such a multilayer film is used as, for example, a backsheet for solar cell module, it is difficult to achieve necessary properties such as shielding property and strength. If the thickness exceeds 500 $\mu$m, there is a possibility that the flexibility of the film may become insufficient. In addition, it is impossible to lighten the weight of the backsheet or to thin the thickness thereof. No particular limitation is imposed on a thickness ratio of the PVDF film to said another thermoplastic resin film in the multilayer film. However, the ratio is preferably 1/99 to 90/10, more preferably 5/95 to 70/30, still more preferably 10/90 to 50/50, particularly preferably 15/85 to 40/60.

8. Production process of multilayer film comprising PVDF film

The multilayer film comprising the PVDF film can be produced by a production process of a multilayer film comprising a PVDF film, which is known *per se* in the art, That is, a co-extrusion process, an extrusion lamination process, a heat sealing process or an adhesive lamination process may be adopted. However, the multilayer film is preferably produced by the adhesive lamination process which is simple.

For the lamination, it is only necessary to bond the PVDF film and said another thermoplastic resin film, which have been formed in advance, to each other without using an adhesive or preferably through an adhesive layer. As an adhesive used in the adhesive lamination, may be used a publicly known adhesive such as an urethane-based adhesive or epoxy-based adhesive, or a hot-melt adhesive. However, a two-pack urethane adhesive is most preferred. The bonding with the adhesive is conducted by subjecting one or both of the PVDF film and said another thermoplastic resin film to a surface-activating treatment if desired, applying an adhesive to form an adhesive layer having a predetermined thickness by heating and drying, and then bonding the PVDF film and said another thermoplastic resin film to each other under pressure while being pressurized by rolls or the like and further while being heated if desired.

9. Solar cell module and backsheet thereof

The PVDF film according to the present invention or the multilayer film comprising the PVDF film is suitable for use as a backsheet for solar cell module.

As examples of a solar cell module, may be mentioned that having the sectional structure illustrated in FIG. 1 as have already stated. That is, as illustrated in FIG. 1, the solar cell module is made up of a front surface protecting material 1, a sealing material 2, solar cells 3 and a back surface protecting material (backsheet) 4. A plurality of the solar cells 3 is connected in series by wirings (not illustrated) to form the solar cell module. A frame (not illustrated) is arranged at end portions or peripheral edge portions of the solar cell module.

As the front surface protecting material 1, is used, for example, a reinforced glass plate, a transparent plastic plate, a single-layer or multilayer transparent plastic film or a composite material with these material composited. However, the front surface protective material is not limited thereto.

As the sealing material 2, is used a transparent resin such as an ethylene-vinyl acetate copolymer (EVA), a butyral resin, a silicon resin, an epoxy resin or a fluorinated polyimide resin. However, the sealing material is not limited thereto. Among these sealing materials, EVA is preferred. The structure of the solar cell 3 varies according to the kind of the solar cell used. However, various kinds of solar cells may be used. When EVA is used as the sealing material 2, EVA is supplied in the form of a sheet. The solar cells 3 are sandwiched between 2 EVA sheets, and the EVA sheets are heated and pressurized, whereby the solar cells may also be sealed with EVA. When the EVA sheet is used as the sealing material 2, the EVA sheet may be supplied in the form composited with the PVDF single-layer film or multilayer film according to the present invention in advance.

As the back surface protecting material (backsheet) 4, may be used the PVDF singly-layer film according to the present invention or a multilayer film comprising a PVDF film, which is composited with the PVDF film and another thermoplastic resin film (for example, PET film). When the multilayer film comprising the PVDF film is used as the backsheet 4 for solar cell module according to the present invention, the PVDF film is preferably arranged on the back surface side most distant from the solar cells 3 in the solar cell module because it is excellent in mechanical properties and weatherability.

The backsheet 4 for solar cell module according to the present invention may be a multilayer film further comprising a barrier layer or a composite material further comprising a reinforced glass plate, metal plate or metal foil. In such a multilayer film and composite material, an adhesive layer may be arranged between respective layers. Examples of the barrier layer include a vapor-deposited layer of an inorganic oxide such as silicon oxide or aluminum oxide, and a vapor-deposited layer of a metal such as aluminum. These vapor-deposited layers may also be used in the form of a vapor-deposited film of an inorganic oxide such as silicon oxide or aluminum oxide or a vapor-deposited film of a metal such as aluminum, which is formed on one surface of a base film. Incidentally, it goes without saying that the reinforced glass plate, metal plate or metal foil described above fulfills a function as the barrier layer. The formation of the barrier layer by forming the vapor-deposited layer or sticking the metal foil may be suitably performed by a publicly known process. The adhesive used in the adhesion is required to prevent adhesive strength to the barrier layer, in particular, the vapor-deposited layer from deteriorating upon outdoor use over a long period of time so as not to cause peeling, and further for the adhesive not to cause yellowing, so that a polyurethane-based adhesive may be preferably used.

EXAMPLES

The present invention will hereinafter be described more specifically by the following Examples and Comparative Examples. However, the present invention is not limited to these Examples. Evaluating methods of physical properties or properties in Examples and Comparative Examples are as follows.

[Proportion of β-type crystal]

The amounts of an α-type crystal and a β-type crystal which are present in a film were determined by measuring an infrared absorption spectrum by a transmission method by means of FT-IR (SPECTRUM 2000) manufactured by Perkin Elmer Co.

Specifically, absorption intensity at a wavenumber of 765 cm$^{-1}$ that is characteristic absorption of the α-type crystal and absorption intensity at a wavenumber of 840 cm$^{-1}$ that is characteristic absorption of the β-type crystal are determined from the resultant infrared absorption spectrum diagram to calculate out a proportion of the β-type crystal according to the following equation.

$$\text{Proportion of β-type crystal} = (\text{Absorption intensity at } 840 \text{ cm}^{-1})/[(\text{Absorption intensity at } 765 \text{ cm}^{-1}) + (\text{Absorption intensity at } 840 \text{ cm}^{-1})] * 100.$$

[Mechanical property - tensile modulus]

The tensile modulus that is mechanical property of a film was measured by using, as a specimen, a strip film having a length of 200 mm and a width of 20 mm and obtained by cutting out the film in parallel with MD or TD according to JIS K 7127, setting the specimen in an oven controlled to a predetermined temperature, controlling the temperature for about 2 seconds and then conducting a tensile test. The predetermined temperature was 23°C (corresponding to room temperature) and higher temperatures at intervals of every 10°C within a range of 30°C to 140°C. The tensile test is performed at a tensile speed of 10 mm/min by using TENSILON RTM-100 manufactured by Toyo Baldwin K.K.

Specifically, the tensile modulus in TD at a temperature of 120°C is a measured value measured by setting the specimen cut out in parallel with TD in an oven controlled to a temperature of 120°C to conduct the tensile test. The temperature ratio between the tensile moduli was calculated out from respective measured values measured by respectively setting the specimens cut out in parallel with TD in an oven controlled to a temperature of 23 °C and an oven controlled to a temperature of 100°C to conduct the tensile test. The measurement was conducted on 5 specimens, and an average value of the respective measured values was regarded as a measured value. The same shall apply hereinafter.

[Mechanical property - breaking strength]

The breaking strength (maximum point stress) that is mechanical property of a film was measured by using, as specimens, strip films each having a length of 150 mm and a width of 10 mm and obtained by cutting out the film in parallel with MD and TD according to JIS K 7127 and conducting a tensile test at a tensile speed of 500 mm/min and ordinary temperature (23°C) by means of the above-described testing machine.

[Evaluation as to wrinkles by heat upon lamination]

Evaluation as to wrinkles by heat upon lamination in a PVDF film was made by producing a laminated film from a PVDF film adjusted so as to have a width of 280 mm by a slitter and a biaxially stretched PET film having a thickness of 75 $\mu$m and a width of 280 mm (LUMIRROR (trademark) T60, product of Toray Industries, Inc.).

The laminated film was produced by the adhesive lamination process and obtained by continuously bonding both films under pressure by nip rolls while sending out both films at a line speed of 5 m/min. A two-pack urethane adhesive available from Mitsui Chemicals, Inc. was used as an adhesive. The adhesive is composed of A-620 as a main agent and A-65 as a hardener, and a solid content concentration thereof was controlled to 35% by mass. The PET film was set on a primary side and sent out under a tension of 10 kgf/m, and the above-described adhesive was applied to a surface of the PET film by a direct gravure system by means of a multicoater manufactured by Hirano Tecseed Co., Ltd. so as to give a dry coating thickness of 10 $\mu$m. The drying of the adhesive was conducted at two steps of a temperature of 60°C and a temperature of 150°C. The PVDF film set on a secondary side was then sent out under a tension of 10 kgf/m to continuously bond both films under pressure by nip rolls, thereby obtaining a laminated film.

The resultant laminated film was caused to pass through a multicoater controlled to the same drying temperature conditions within 2 hours from the production to wind the film on the secondary side. A film 100 mm square was cut out of the resultant film to visually observe conditions of wrinkles by heat of this film.

Evaluation standard is as follows.

A: No wrinkle is observed on the PVDF film in both MD and TD;

B: Wrinkles are observed on the PVDF film along MD or TD.

[Example 1]

One hundred parts by mass of PVDF [KF (trademark) #850, product of KUREHA CORPORATION], 55.6 parts by mass of titanium oxide [TI-PURE (trademark) R101, product of Du Pont Co.; rutile-type titanium oxide, average particle diameter: 0.29 $\mu$m, surface-treated product], 23.4 parts by mass of PMMA [DELPOWDER (trademark) 70H, product of ASAHI KASEI CHEMICALS CORPORATION], 2.5 parts by mass of an acrylic elastomer [PALALOID (trademark) EXL-2315, product of Rohm and Haas Co.], 2.8 parts by mass of calcium carbonate [SL2500, product of TAKEHARA KAGAKU KOGYO CO., LTD.], 0.9 parts by mass of calcium stearate [product of NITTO KASEI CO., LTD.] and 0.04 parts by mass of carbon black [DENKA BLACK (trademark), product of Denki Kagaku Kogyo Kabushiki Kaisha] were fed to a twin-screw extruder, melted and kneaded at a temperature of 220°C and melt-extruded in the form of strand from a die, and the resultant strand was cooled and then cut to obtain pellets for film formation.

The resultant pellets were fed to a single-screw extruder and melted at a temperature of 220°C, and the melted resin was extruded below in the form of a sheet from a T-die having a width of 500 mm (shear rate at a T-die opening: 39 sec$^{-1}$). The sheet-shaped material was brought into close contact with a first casting roll whose surface temperature was controlled to 30°C and which had a diameter of 30 cm at a position of 100 mm just under the T-die opening to cool the sheet-shaped material [cooling time (time from the extrusion from the die to separation from the first casting roll): 10 seconds], and the cooled sheet-shaped material was then caused to pass through 4 metal rolls (R2 to R5) retained at ordinary temperature without making temperature control to produce a PVDF film having a thickness of 20 $\mu$m. The PVDF film was wound around a paper tube. A film-forming speed was 3.2 m/min. Results that a proportion of a $\beta$-type crystal in the resultant PVDF film was determined, and the mechanical properties thereof were measured, and an evaluation result as to wrinkles by heat upon lamination are shown in Table 1.

[Example 2]

A PVDF film having a thickness of 20 $\mu$m was obtained in the same manner as in Example 1 except that the surface temperature of the first casting roll was changed to 50°C. Results that a proportion of a $\beta$-type crystal in the resultant PVDF film was determined, and the mechanical properties thereof were measured, and an evaluation result as to wrinkles by heat upon lamination are shown in Table 1.

[Example 3]

A PVDF film having a thickness of 20 $\mu$m was obtained in the same manner as in Example 1 except that the surface temperature of the first casting roll was changed to 15°C. Results that a proportion of a $\beta$-type crystal in the resultant PVDF film was determined, and the mechanical properties thereof were measured, and an evaluation result as to wrinkles by heat upon lamination are shown in Table 1.

[Example 4]

A PVDF film having a thickness of 20 $\mu$m was obtained in the same manner as in Example 1 except that the surface temperature of the first casting roll was changed to 15°C, and the shear rate at the T-die opening was changed to 22 sec$^{-1}$ (the extrusion rate from the single-screw extruder was reduced) to control the film-forming speed. The cooling time was 16 seconds. Results that a proportion of a $\beta$-type crystal in the resultant PVDF film was determined, and the mechanical properties thereof were measured, and an evaluation result as to wrinkles by heat upon lamination are shown in Table 1.

[Example 5]

A PVDF film having a thickness of 20 $\mu$m was obtained in the same manner as in Example 1 except that the surface temperature of the first casting roll was changed to 15°C, and the shear rate at the T-die opening was changed to 9 sec$^{-1}$ to control the film-forming speed. The cooling time was 32 seconds. Results that a proportion of a $\beta$-type crystal in the resultant PVDF film was determined, and the mechanical properties thereof were measured, and an evaluation result as to wrinkles by heat upon lamination are shown in Table 1.

[Example 6]

A PVDF film having a thickness of 20 $\mu$m was obtained in the same manner as in Example 1 except that the surface temperature of the first casting roll was changed to 15°C, and the shear rate at the T-die opening was changed to 4 sec$^{-1}$ to control the film-forming speed. The cooling time was 70 seconds. Results that a proportion of a $\beta$-type crystal in the resultant PVDF film was determined, and the mechanical properties thereof were measured, and an evaluation result as to wrinkles by heat upon lamination are shown in Table 1.

[Example 7]

The PVDF film obtained in Example 1 was left at rest in a chamber temperature-controlled to 115°C for 2 hours in the state wound around the paper tube as it is, so as to conduct a heat treatment, thereby obtaining a PVDF film. Results that a proportion of a $\beta$-type crystal in the resultant PVDF film was determined, and the mechanical properties thereof were measured, and an evaluation result as to wrinkles by heat upon lamination are shown in Table 1.

[Comparative Examples 1 to 4]

PVDF films each having a thickness of 20 $\mu$m were obtained in the same manner as in Example 1 except that the surface temperature of the first casting roll was changed to 78°C (Comparative Example 1), 90°C (Comparative Example 2), 110°C (Comparative Example 3) and 115°C (Comparative Example 4), respectively. Results that proportions of a $\beta$-type crystal in the resultant PVDF films were determined, and the mechanical properties thereof were measured, and evaluation results as to wrinkles by heat upon lamination are shown in Table 1.

[Table 1]

| Ex.No. | Thickness (μm) | Temperature of first casting roll (°C) | Temperature of second to fifth rolls (°C) | Heat treatment in a state wound on roll | Proportion of β-type crystal (%) | Tensile modulus in TD (MPa) | | | | | | | | | | | | | Breaking strength (23°C, MPa) | | Evaluation of wrinkles by heat upon lamination |
|---|---|---|---|---|---|---|---|---|---|---|---|---|---|---|---|---|---|---|---|---|---|
| | | | | | | Temperature (°C) | | | | | | | | | | | | | | | |
| | | | | | | 23 | 30 | 40 | 50 | 60 | 70 | 80 | 90 | 100 | 110 | 120 | 130 | 140 | MD | TD | |
| Ex.1 | 20 | 30 | Ordinary temperature | - | 100 | 1960 | 1510 | 970 | 830 | 400 | 48 | 38 | 29 | 22 | 19 | 16 | 14 | 8 | 38 | 31 | A |
| Ex.2 | 20 | 50 | Ordinary temperature | - | 60 | 1930 | 1540 | 1100 | 950 | 400 | 75 | 63 | 49 | 41 | 36 | 32 | 23 | 16 | 41 | 29 | A |
| Ex.3 | 20 | 15 | Ordinary temperature | - | 100 | 1200 | 1010 | 850 | 350 | 53 | 41 | 37 | 30 | 20 | 18 | 16 | 10 | 7 | 32 | 31 | A |
| Ex.4 | 20 | 15 | Ordinary temperature | - | 100 | 1460 | 1060 | 940 | 42 | 52 | 35 | 32 | 30 | 19 | 17 | 15 | 10 | 8 | 32 | 30 | A |
| Ex.5 | 20 | 15 | Ordinary temperature | - | 100 | 1490 | 1240 | 920 | 550 | 47 | 35 | 35 | 32 | 19 | 17 | 16 | 11 | 8 | 30 | 27 | A |
| Ex.6 | 20 | 15 | Ordinary temperature | - | 100 | 1670 | 1320 | 980 | 630 | 49 | 47 | 40 | 34 | 18 | 17 | 17 | 11 | 9 | 30 | 28 | A |
| Ex.7 | 20 | 30 | Ordinary temperature | 115°C, 2hrs. | 100 | 1980 | 1830 | 1660 | 1210 | 990 | 560 | 380 | 160 | 67 | 45 | 30 | 18 | 13 | 40 | 39 | A |
| Comp. Ex.1 | 20 | 78 | Ordinary temperature | - | 2 | 2380 | 2000 | 1380 | 1080 | 550 | 190 | 140 | 130 | 100 | 82 | 66 | 63 | 50 | 44 | 38 | B |
| Comp. Ex.2 | 20 | 90 | Ordinary temperature | - | 4 | 3000 | 2210 | 1760 | 1330 | 800 | 330 | 210 | 180 | 150 | 140 | 120 | 86 | 74 | 49 | 41 | B |
| Comp. Ex.3 | 20 | 110 | Ordinary temperature | - | 1 | 2900 | 2230 | 1500 | 1380 | 840 | 320 | 250 | 190 | 170 | 150 | 120 | 98 | 65 | 51 | 42 | B |
| Comp. Ex.4 | 20 | 115 | Ordinary temperature | - | 3 | 3070 | 2340 | 1760 | 1480 | 900 | 340 | 260 | 190 | 170 | 150 | 130 | 100 | 67 | 48 | 41 | B |

It was understood from Table 1 that in the PVDF films (the film of Example 7 is a PVDF film obtained by further conducting a heat treatment in a state wound around a roll) of Examples 1 to 7, which were obtained by quenching respective PVDF sheet-shaped materials melt-extruded on the first casting roll controlled to a temperature of 15 to 50°C, the proportion of the β-type crystal is 100% or 60%, and the occurrence of wrinkles by heat is not observed upon lamination with the PET film. In particular, it was understood that in the PVDF film of Example 7, which was obtained by further conducting the heat treatment in the state wound around the roll, the tensile modulus in TD is not lowered up to a high-temperature region, and so the film is a film excellent in heat resistance.

On the other hand, it was understood that in the PVDF films of Comparative Examples 1 to 4, which were obtained by cooling respective PVDF sheet-shaped materials melt-extruded on the first casting roll controlled to a temperature exceeding 70°C, the proportion of the β-type crystal is less than 10%, and the occurrence of wrinkles by heat is observed upon lamination with the PET film.

[Example 8]

A PVDF film having a thickness of 20 μm was obtained in the same manner as in Example 1 except that the surface temperature of the first casting roll was changed to 20°C, the surface temperatures of the 4 metal rolls, that is, the second, third, fourth and fifth metal rolls were changed to 90°C to subject the sheet-shaped material to a heat treatment, a roll having a diameter of 50 cm was used as the first casting roll, and the extrusion rate and a die lip clearance were adjusted to change the film-forming speed to 20 m/min (melting temperature of pellets in the single-screw extruder: 230°C). Results that a proportion of a β-type crystal in the resultant PVDF film was determined, and the mechanical properties thereof were measured, and an evaluation result as to wrinkles by heat upon lamination are shown in Table 2.

[Example 9]

A PVDF film having a thickness of 20 μm was obtained in the same manner as in Example 8 except that the film-forming speed was changed to 35 m/min. Results that a proportion of a β-type crystal in the resultant PVDF film was determined, and the mechanical properties thereof were measured, and an evaluation result as to wrinkles by heat upon lamination are shown in Table 2.

[Example 10]

A PVDF film having a thickness of 20 μm was obtained in the same manner as in Example 8 except that the film-forming speed was changed to 45 m/min. Results that a proportion of a β-type crystal in the resultant PVDF film was determined, and the mechanical properties thereof were measured, and an evaluation result as to wrinkles by heat upon lamination are shown in Table 2.

[Example 11]

A PVDF film having a thickness of 20 μm was obtained in the same manner as in Example 8 except that the surface temperature of the first casting roll was changed to 30°C. Results that a proportion of a β-type crystal in the resultant PVDF film was determined, and the mechanical properties thereof were measured, and an evaluation result as to wrinkles by heat upon lamination are shown in Table 2.

[Example 12]

A PVDF film having a thickness of 20 μm was obtained in the same manner as in Example 10 except that the surface temperature of the first casting roll was changed to 50°C. Results that a proportion of a β-type crystal in the resultant PVDF film was determined, and the mechanical properties thereof were measured, and an evaluation result as to wrinkles by heat upon lamination are shown in Table 2.

[Example 13]

A PVDF film having a thickness of 20 μm was obtained in the same manner as in Example 10 except that the surface temperature of the first casting roll was changed to 60°C. Results that a proportion of a β-type crystal in the resultant PVDF film was determined, and the mechanical properties thereof were measured, and an evaluation result as to wrinkles by heat upon lamination are shown in Table 2.

[Example 14]

A PVDF film having a thickness of 20 $\mu$m was obtained in the same manner as in Example 10 except that the surface temperature of the first casting roll was changed to 65°C, and the surface temperatures of the 4 metal rolls, that is, the second, third, fourth and fifth metal rolls were changed to 110°C to subject the sheet-shaped material to a heat treatment. Results that a proportion of a $\beta$-type crystal in the resultant PVDF film was determined, and the mechanical properties thereof were measured, and an evaluation result as to wrinkles by heat upon lamination are shown in Table 2.

[Example 15]

A PVDF film having a thickness of 15 $\mu$m was obtained in the same manner as in Example 10 except that the amount of the pellets fed to the single-screw extruder was reduced. Results that a proportion of a $\beta$-type crystal in the resultant PVDF film was determined, and the mechanical properties thereof were measured, and an evaluation result as to wrinkles by heat upon lamination are shown in Table 2.

[Example 16]

The PVDF film obtained in Example 10 was left at rest in a chamber temperature-controlled to 115°C for 2 hours in the state wound around the paper tube as it is, so as to conduct a heat treatment, thereby obtaining a PVDF film. Results that a proportion of a $\beta$-type crystal in the resultant PVDF film was determined, and the mechanical properties thereof were measured, and an evaluation result as to wrinkles by heat upon lamination are shown in Table 2.

[Example 17]

A PVDF film obtained according to the process of Example 10 was left at rest in a chamber temperature-controlled to 80°C for 2 hours in the state wound around the paper tube as it is, so as to conduct a heat treatment, thereby obtaining a PVDF film. Results that a proportion of a $\beta$-type crystal in the resultant PVDF film was determined, and the mechanical properties thereof were measured, and an evaluation result as to wrinkles by heat upon lamination are shown in Table 2.

[Comparative Example 5]

A PVDF film having a thickness of 20 $\mu$m was obtained in the same manner as in Example 10 except that the surface temperature of the first casting roll was changed to 90°C. Results that a proportion of a $\beta$-type crystal in the resultant PVDF film was determined, and the mechanical properties thereof were measured, and an evaluation result as to wrinkles by heat upon lamination are shown in Table 2.

[Comparative Example 6]

A PVDF film having a thickness of 20 $\mu$m was obtained in the same manner as in Example 9 except that the surface temperature of the first casting roll was changed to 105°C. Results that a proportion of a $\beta$-type crystal in the resultant PVDF film was determined, and the mechanical properties thereof were measured, and an evaluation result as to wrinkles by heat upon lamination are shown in Table 2.

[Comparative Example 7]

A PVDF film having a thickness of 20 $\mu$m was obtained in the same manner as in Comparative Example 6 except that the film-forming speed was changed to 45 m/min. Results that a proportion of a $\beta$-type crystal in the resultant PVDF film was determined, and the mechanical properties thereof were measured, and an evaluation result as to wrinkles by heat upon lamination are shown in Table 2.

EP 2 722 362 A1

[Table 2]

| Ex. No. | Thickness (μm) | Temperature of first casting roll (°C) | Temperature of second to fifth rolls (°C) | Heat treatment in a state wound on roll | Proportion of β-type crystal (%) | Tensile modulus in TD (MPa) | | | | | | | | | | | | | Breaking strength (23°C, MPa) | | Evaluation of wrinkles by heat upon lamination |
|---|---|---|---|---|---|---|---|---|---|---|---|---|---|---|---|---|---|---|---|---|---|
| | | | | | | Temperature (°C) | | | | | | | | | | | | | | | |
| | | | | | | 23 | 30 | 40 | 50 | 60 | 70 | 80 | 90 | 100 | 110 | 120 | 130 | 140 | MD | TD | |
| Ex.8 | 20 | 20 | 90 | - | 100 | 2230 | 1720 | 1120 | 830 | 550 | 120 | 72 | 37 | 32 | 27 | 19 | 17 | 13 | 59 | 38 | A |
| Ex.9 | 20 | 20 | 90 | - | 100 | 2210 | 1750 | 1050 | 810 | 530 | 110 | 63 | 35 | 27 | 24 | 18 | 15 | 11 | 48 | 38 | A |
| Ex. 10 | 20 | 20 | 90 | - | 100 | 2200 | 1680 | 920 | 790 | 520 | 100 | 65 | 33 | 29 | 24 | 17 | 14 | 11 | 48 | 38 | A |
| Ex. 11 | 20 | 30 | 90 | - | 100 | 2350 | 1850 | 1200 | 840 | 570 | 140 | 82 | 50 | 42 | 33 | 25 | 22 | 18 | 45 | 41 | A |
| Ex. 12 | 20 | 50 | 90 | - | 45 | 2600 | 1980 | 1360 | 1040 | 820 | 130 | 90 | 58 | 42 | 38 | 31 | 25 | 20 | 53 | 39 | A |
| Ex.13 | 20 | 60 | 90 | - | 70 | 2630 | 2020 | 1220 | 950 | 620 | 210 | 140 | 93 | 83 | 67 | 64 | 46 | 35 | 50 | 43 | A |
| Ex. 14 | 20 | 65 | 110 | - | 55 | 2700 | 2100 | 1300 | 1020 | 720 | 220 | 160 | 100 | 93 | 72 | 62 | 45 | 40 | 52 | 48 | A |
| Ex.15 | 15 | 20 | 90 | - | 100 | 2480 | 1750 | 1240 | 1130 | 730 | 110 | 58 | 30 | 24 | 22 | 20 | 14 | 10 | 63 | 37 | A |
| Ex.16 | 20 | 20 | 90 | 115°C, 2hrs. | 100 | 2110 | 1870 | 1600 | 970 | 820 | 410 | 310 | 100 | 61 | 45 | 30 | 20 | 12 | 53 | 37 | A |
| Ex.17 | 20 | 20 | 90 | 80°C, 2 hrs. | 100 | 1880 | 1790 | 1310 | 850 | 650 | 330 | 200 | 78 | 27 | 20 | 16 | 12 | 10 | 49 | 36 | A |
| Comp. Ex.5 | 20 | 90 | 90 | - | 3 | 2580 | 1980 | 1220 | 990 | 720 | 300 | 220 | 150 | 130 | 110 | 95 | 84 | 60 | 51 | 46 | B |
| Comp. Ex.6 | 20 | 105 | 90 | - | 4 | 3190 | 2450 | 1760 | 1310 | 770 | 330 | 270 | 220 | 160 | 150 | 120 | 88 | 71 | 57 | 49 | B |
| Comp. Ex.7 | 20 | 105 | 90 | - | 3 | 2680 | 2060 | 1250 | 1090 | 840 | 330 | 230 | 160 | 140 | 120 | 100 | 94 | 65 | 52 | 48 | B |

It was understood from Table 2 that in the PVDF films (the films of Examples 16 and 17 are PVDF films obtained by further conducting a heat treatment in a state wound around a roll) of Examples 8 to 17, which were obtained by quenching respective PVDF sheet-shaped materials melt-extruded on the first casting roll controlled to a temperature of 20 to 65°C and conducting the heat treatment on the second to fifth rolls controlled to a temperature of 90°C or 110°C, the proportion of the β-type crystal is 45 to 100%, and the occurrence of wrinkles by heat is not observed upon lamination with the PET film. It was also understood that since the tensile modulus in TD at room temperature (23°C) is 1,800 MPa or more that is preferable for practical use, such films have sufficient mechanical strength under an actual service environment and in the lamination process. In particular, it was understood that in the PVDF films of Examples 16 and 17, which were obtained by further conducting the heat treatment in the state wound around the roll, the tensile modulus in TD is not lowered up to a high-temperature region, and so the films are films excellent in heat resistance.

On the other hand, it was understood that in the PVDF films of Comparative Examples 5 to 7, which were obtained by cooling respective PVDF sheet-shaped materials melt-extruded on the first casting roll controlled to a temperature exceeding 70°C, the proportion of the β-type crystal is less than 10%, the tensile modulus in TD at a temperature of 120°C exceeds 90 MPa, and so the occurrence of wrinkles by heat is observed upon lamination with the PET film.

With respect to the PVDF films of Examples 1 to 17 and Comparative Examples 1 to 7, tensile moduli in MD at temperatures of 23°C, 100°C and 120°C were measured. Their measured values are shown in Table 3 together with measured values of tensile moduli in TD at temperatures of 23°C, 100°C and 120°C and breaking strength in both TD and MD shown in Table 1 and 2.

[Table 3]

| Ex. No. | Thickness (μm) | Proportion of β-type crystal (%) | Direction | Tensile modulus (MPa) | | | Temperature ratio between tensile moduli (%) | Breaking strength (23°C, MPa) | Evaluation of wrinkles by heat upon lamination |
|---------|---------|---------|-----------|------|-------|-------|---------|---------|---------|
| | | | | Temperature (°C) | | | | | |
| | | | | 23°C | 100°C | 120°C | | | |
| Ex.1 | 20 | 100 | MD | 1180 | 23 | 15 | 1.95 | 38 | A |
| | | | TD | 1960 | 22 | 16 | 1.12 | 31 | |
| Ex.2 | 20 | 60 | MD | 1170 | 25 | 22 | 2.14 | 41 | A |
| | | | TD | 1930 | 41 | 32 | 2.12 | 29 | |
| Ex.3 | 20 | 100 | MD | 1200 | 24 | 15 | 2.00 | 32 | A |
| | | | TD | 1200 | 20 | 16 | 1.67 | 31 | |
| Ex.4 | 20 | 100 | MD | 1460 | 23 | 15 | 1.58 | 32 | A |
| | | | TD | 1460 | 19 | 15 | 1.30 | 30 | |
| Ex.5 | 20 | 100 | MD | 1410 | 23 | 13 | 1.63 | 30 | A |
| | | | TD | 1490 | 19 | 16 | 1.28 | 27 | |
| Ex.6 | 20 | 100 | MD | 1470 | 25 | 16 | 1.70 | 30 | A |
| | | | TD | 1670 | 18 | 17 | 1.08 | 28 | |
| Ex.7 | 20 | 100 | MD | 1900 | 63 | 35 | 3.32 | 40 | A |
| | | | TD | 1980 | 67 | 30 | 3.38 | 39 | |
| Ex.8 | 20 | 100 | MD | 1740 | 23 | 18 | 1.32 | 59 | A |
| | | | TD | 2230 | 32 | 19 | 1.43 | 38 | |
| Ex.9 | 20 | 100 | MD | 1690 | 22 | 17 | 1.30 | 48 | A |
| | | | TD | 2210 | 27 | 18 | 1.22 | 38 | |
| Ex.10 | 20 | 100 | MD | 1680 | 22 | 16 | 1.31 | 48 | A |
| | | | TD | 2200 | 29 | 17 | 1.32 | 38 | |
| Ex.11 | 20 | 100 | MD | 1620 | 32 | 20 | 1.98 | 45 | A |
| | | | TD | 2350 | 42 | 25 | 1.79 | 41 | |

| Ex. No. | Thickness (μm) | Proportion of β-type crystal (%) | Tensile modulus (MPa) | | | | | Breaking strength (23°C, MPa) | Evaluation of wrinkles by heat upon lamination |
|---------|----------------|----------------------------------|----------------------|--|--|--|--|-------------------------------|-------------------------------------------------|
| | | | Direction | Temperature (°C) | | | Temperature ratio between tensile moduli (%) | | |
| | | | | 23°C | 100°C | 120°C | | | |
| Ex.12 | 20 | 45 | MD | 1900 | 77 | 42 | 4.05 | 53 | A |
| | | | TD | 2600 | 42 | 31 | 1.62 | 39 | |
| Ex. 13 | 20 | 70 | MD | 2380 | 42 | 24 | 1.76 | 50 | A |
| | | | TD | 2630 | 83 | 64 | 3.16 | 43 | |
| Ex. 14 | 20 | 55 | MD | 2630 | 94 | 58 | 3.57 | 52 | A |
| | | | TD | 2700 | 93 | 62 | 3.44 | 48 | |
| Ex. 15 | 15 | 100 | MD | 2090 | 26 | 17 | 1.24 | 63 | A |
| | | | TD | 2480 | 24 | 20 | 0.97 | 37 | |
| Ex. 16 | 20 | 100 | MD | 1940 | 61 | 40 | 3.14 | 53 | A |
| | | | TD | 2110 | 61 | 30 | 2.89 | 37 | |
| Ex.17 | 20 | 100 | MD | 1990 | 26 | 14 | 1.31 | 49 | A |
| | | | TD | 1880 | 27 | 16 | 1.44 | 36 | |
| Comp. Ex. 1 | 20 | 2 | MD | 2050 | 95 | 67 | 4.63 | 44 | B |
| | | | TD | 2380 | 100 | 66 | 4.20 | 38 | |
| Comp. Ex. 2 | 20 | 4 | MD | 2570 | 125 | 89 | 4.86 | 49 | B |
| | | | TD | 3000 | 150 | 120 | 5.00 | 41 | |
| Comp. Ex. 3 | 20 | 1 | MD | 2150 | 121 | 82 | 5.63 | 51 | B |
| | | | TD | 2900 | 170 | 120 | 5.86 | 42 | |
| Comp. Ex. 4 | 20 | 3 | MD | 2590 | 132 | 89 | 5.10 | 48 | B |
| | | | TD | 3070 | 170 | 130 | 5.54 | 41 | |
| Comp. Ex. 5 | 20 | 3 | MD | 2150 | 120 | 88 | 5.58 | 51 | B |
| | | | TD | 2580 | 130 | 95 | 5.04 | 46 | |

(continued)

| Ex. No. | Thickness (μm) | Proportion of β-type crystal (%) | Tensile modulus (MPa) | | | | | Breaking strength (23°C, MPa) | Evaluation of wrinkles by heat upon lamination |
|---|---|---|---|---|---|---|---|---|---|
| | | | Direction | Temperature (°C) | | | Temperature ratio between tensile moduli (%) | | |
| | | | | 23°C | 100°C | 120°C | | | |
| Comp. Ex.6 | 20 | 4 | MD | 2710 | 110 | 77 | 4.06 | 57 | B |
| | | | TD | 3190 | 160 | 120 | 5.02 | 49 | |
| Comp. Ex. 7 | 20 | 3 | MD | 2170 | 120 | 91 | 5.53 | 52 | B |
| | | | TD | 2680 | 140 | 100 | 5.22 | 48 | |

It was understood from Table 3 that In the PVDF film of Example 1 to 17 in which the proportion of the β-type crystal is 45 to 100%, the temperature ratio between tensile moduli (ratio of the tensile modulus in TD at the temperature of 100°C to the tensile modulus in TD at the temperature of 23°C) is 0.97 to 3.44%, and the occurrence of wrinkles by heat is not observed upon lamination with the PET film. In the PVDF films of Example 1 to 17, the degree of lowering of the tensile modulus in TD become great as the temperature rises, and such a film has high probability that the tensile modulus in TD falls within less than 120 MPa in an environment of a temperature of 100°C or higher, which is generally adopted in a lamination step, so that the flexibility of the film is easily retained. It was thus inferred that the film does not have such force as to cause the deformation of an adhesive for lamination, and so the occurrence of wrinkles by heat upon the lamination can be more surely prevented.

On the other hand, in the PVDF films of Comparative Examples 1 to 7, in which the proportion of the β-type crystal is less than 10%, and the occurrence of wrinkles by heat is observed upon the lamination with the PET film, the temperature ratio between tensile moduli thereof exceeds 4%, so that the degree of lowering of the tensile modulus in TD is insufficient as the temperature rises, and so such a film has low probability that the tensile modulus in TD falls within less than 120 MPa in the environment of a temperature of 100°C or higher, which is generally adopted in the lamination step. It was thus inferred that the adhesive for lamination is deformed, and so the occurrence of wrinkles by heat upon the lamination cannot be prevented.

INDUSTRIAL APPLICABILITY

Since the PVDF film according to the present invention, in which the crystal structure determined from the absorbance by the infrared absorption spectrum is such that the proportion of the β-type crystal is 10% or more when the sum total of the α-type crystal and the β-type crystal is regarded as 100%, is a film which has excellent mechanical properties and is free of occurrence of wrinkles by heat upon lamination under heat, the film can be used as a backsheet for solar cell module, which is rich in long-term reliability, in the form of a single-layer film or multilayer film, so that the film has high industrial applicability. In addition, since the PVDF film having the above-described excellent properties can be produced by a simple process in which a PVDF sheet-shaped material melt-extruded is quenched and preferably then subjected to a heat treatment, the present invention is high in industrial applicability.

REFERENCE SIGNS LIST

    1: Front surface protecting material
    2: Sealing material
    3: Solar cell
    4: Back surface protecting material (backsheet)

**Claims**

1. A polyvinylidene fluoride resin film in which a crystal structure determined from an absorbance by an infrared absorption spectrum is such that a proportion of a β-type crystal is 10% or more when the sum total of an α-type crystal and the β-type crystal is regarded as 100%.

2. The polyvinylidene fluoride resin film according to claim 1, which comprises 100 parts by mass of a polyvinylidene fluoride resin, 0 to 40 parts by mass of another thermoplastic resin and 5 to 100 parts by mass of titanium oxide.

3. The polyvinylidene fluoride resin film according to claim 1 or 2, wherein the thickness thereof is 10 to 50 μm.

4. The polyvinylidene fluoride resin film according to any one of claims 1 to 3, wherein the film is an extruded film.

5. The polyvinylidene fluoride resin film according to any one of claims 1 to 4, wherein its tensile modulus in TD at a temperature of 120°C is 90 MPa or less.

6. The polyvinylidene fluoride resin film according to any one of claims 1 to 5, wherein a ratio of its tensile modulus in TD at a temperature of 100°C to its tensile modulus in TD at a temperature of 23°C is 4% or less.

7. A multilayer film comprising the polyvinylidene fluoride resin film according to any one of claims 1 to 6.

8. A backsheet for solar cell module, comprising the polyvinylidene fluoride resin film according to any one of claims 1 to 7.

9. A production process of the polyvinylidene fluoride resin film according to any one of claims 1 to 6, comprising quenching a sheet-shaped material melt-extruded at a temperature of 5 to 70°C.

10. The production process of the polyvinylidene fluoride resin film according to claim 9, wherein the sheet-shaped material quenched is subjected to a heat treatment at a temperature of 75 to 150°C.

[Fig. 1]

[Fig. 2]

[Fig. 3]

## INTERNATIONAL SEARCH REPORT

| | International application No. |
|---|---|
| | PCT/JP2012/061331 |

**A. CLASSIFICATION OF SUBJECT MATTER**
*C08L27/16*(2006.01)i, *B32B27/30*(2006.01)i, *C08K3/22*(2006.01)i, *H01L31/042*
(2006.01)i

According to International Patent Classification (IPC) or to both national classification and IPC

**B. FIELDS SEARCHED**

Minimum documentation searched (classification system followed by classification symbols)
C08L27/16, B32B27/30, C08K3/22, H01L31/042

Documentation searched other than minimum documentation to the extent that such documents are included in the fields searched
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2006-241195 A (National Institute of Advanced Industrial Science and Technology), 14 September 2006 (14.09.2006), claims; paragraphs [0011], [0012]; examples; fig. 6, 7 (Family: none) | 1,3-6,9,10<br>7<br>2,8 |
| X<br>Y<br>A | JP 03-015005 A (Kureha Chemical Industry Co., Ltd.), 23 January 1991 (23.01.1991), claims; page 3, lower left column, lines 4 to 9; page 6, upper right column, lines 4 to 7; page 6, lower right column, lines 2 to 7; examples<br>& US 5042924 A & EP 386711 A1<br>& DE 69015844 C & DE 69015844 D<br>& CA 2011620 A & KR 10-1992-0007285 B<br>& CA 2011620 A1 | 1,3-6,9,10<br>7,9,10<br>2,8 |

☒ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>29 June, 2012 (29.06.12) | Date of mailing of the international search report<br>10 July, 2012 (10.07.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/061331

C (Continuation). DOCUMENTS CONSIDERED TO BE RELEVANT

| Category* | Citation of document, with indication, where appropriate, of the relevant passages | Relevant to claim No. |
|---|---|---|
| X<br>Y<br>A | JP 62-193812 A (Eastman Kodak Co.),<br>26 August 1987 (26.08.1987),<br>claims; page 2, upper left column, lines 16 to<br>20; page 2, lower right column, lines 14 to 20;<br>page 3, upper left column, lines 9 to 19<br>& US 4711808 A            & EP 237709 A1<br>& CA 1288725 A | 1,3-7,9<br>8,10<br>2 |
| X<br>Y | JP 60-040137 A (Kureha Chemical Industry Co.,<br>Ltd.),<br>02 March 1985 (02.03.1985),<br>claims; page 3, upper left column, lines 7 to<br>11; page 3, lower left column, lines 9 to 12;<br>page 3, lower right column, line 19 to page 4,<br>upper left column, line 3; page 4, upper right<br>column, lines 11 to 13; examples<br>& US 4615943 A            & GB 2145030 A<br>& GB 8420609 A0            & DE 3429767 A<br>& FR 2566323 A            & CA 1251893 A | 1,3-7<br>2,8-10 |
| X<br>Y<br>A | JP 05-249315 A (Kureha Chemical Industry Co.,<br>Ltd.),<br>28 September 1993 (28.09.1993),<br>claims; paragraphs [0024], [0031], [0032],<br>[0034]; examples<br>(Family: none) | 1,3-7,9,10<br>7,9,10<br>2,8 |
| Y<br>A | JP 2008-273832 A (Showa Denko Kabushiki<br>Kaisha),<br>13 November 2008 (13.11.2008),<br>claims; paragraph [0053]<br>(Family: none) | 2<br>1,3-10 |
| Y<br>A | WO 2010/122936 A1 (Kureha Corp.),<br>28 October 2010 (28.10.2010),<br>claims<br>& EP 2423259 A1            & KR 10-2012-0001808 A | 8<br>1-7,9,10 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003347570 A
- JP 2003251765 A
- JP 2008181929 A
- JP 2009071236 A